# EUROPEAN PATENT APPLICATION

(11) **EP 3 984 954 A1**
(43) Date of publication of application: **20.04.2022**
(21) Application number: 20826087.7
(22) Date of filing: 28.05.2020
(51) Int. Cl.: C01B 33/035

(54) **ROD-SHAPED BODY, JIG, DETACHMENT METHOD AND METHOD FOR MANUFACTURING SILICON ROD**

(30) Priority: 17.06.2019 JP 2019111969
(71) Applicant: Tokuyama Corporation, Shunan-shi, Yamaguchi 745-8648 (JP)
(72) Inventor: KAWAGUCHI, Kazuhiro, Shunan-shi, Yamaguchi 745-8648 (JP)
(74) Representative: Bittner, Thomas L.
(86) International application number: PCT/JP2020/021228
(87) International publication number: WO 2020/255672

(57) **Abstract**

A rod-shaped body (10) is used to lift a cover (103) so as to detach the cover from a bottom plate (101), together with which the cover (103) forms a reactor (100). The rod-shaped body (10) includes a first part (11) to be inserted into a bottom plate-side hole (102a) provided in a surrounding area of the bottom plate (101) and a second part (12) to be inserted into a cover-side hole (104a) disposed in a surrounding area of the cover (103) so as to face the bottom plate-side hole (102a). (Fig. 1)

## Description

The present invention relates to a rod-shaped body, a jig, a method for detaching a cover of a reactor, the rod-shaped body, the jig, and the method each being used during the manufacture of a silicon rod, and to a method for manufacturing a silicon rod.

### Background

High-purity polysilicon is useful as a raw material for manufacturing single-crystal silicon for semiconductors by the Czochralski method (CZ method) or the floating zone method (FZ method). High-purity polysilicon is also useful as a raw material for manufacturing polycrystalline silicon for solar cells by a casting method to which a unidirectional solidification method is applied.

Polysilicon is typically manufactured by a Siemens process. In the Siemens process, a silicon-containing gas and hydrogen are put into a reactor, and the silicon-containing gas and the hydrogen that have been put into the reactor react with each other on a silicon core wire which is heated by the passage of electric current therethrough in the reactor, so that polysilicon is deposited on the silicon core wire. As the silicon-containing gas, monosilane (SiH₄) or trichlorosilane (SiHCl₃) is used.

The most common reactor is composed of a bell-shaped shell and a bottom plate which are made of metal and are capable of being cooled. The bottom plate is provided with many electrodes on which silicon core wires are set upright, an inlet through which a source material gas is to be introduced, and an outlet through which a gas inside the reactor is to be discharged.

The silicon core wires are each typically formed in a U-shape by two vertical rods and one horizontal bridge rod and are set upright in an inverted U-shape so as to be perpendicular to the electrodes provided on the bottom plate of the reactor. Polysilicon that is deposited on the silicon core wire grows with time in a direction in which the diameter of the silicon core wire extends. The reaction is ended when the diameter of the deposited polysilicon reaches a predetermined diameter. Silicon rods (polysilicon) which have stopped growing are cooled down typically to room temperature. Inverted U-shaped silicon rods thus obtained have a height of several meters and each have a weight of several tens of kilograms.

The silicon rods are taken out of the reactor after being cooled to room temperature. Since the

Siemens process is not a continuous process but a batch process, it is necessary to temporarily shut down the reactor upon the end of the deposition, open the reactor, and take the obtained silicon rod out of the reactor. The reactor is opened typically by slowly lifting upward a cover of the reactor that is bell-shaped. The silicon rods are taken out of the reactor such that the inverted U-shaped silicon rods are lifted one by one and moved to the outside of the reactor. The silicon rods are loaded on, for example, a carrier and transferred.

For example, Patent Literatures 1 through 3 disclose techniques for taking a silicon rod out of a reactor. Patent Literatures 1 and 2 disclose techniques for slowly lifting a cover of a reactor upward and taking, out of a bottom plate of the reactor one by one or in groups of two or more, inverted U-shaped silicon rods that are standing upright on the bottom plate of the reactor. Patent Literature 3 discloses a technique in which, by providing a protective wall around a reactor, it is possible to prevent silicon rods from being scattered outside the protective wall in a case where the silicon rods fall over in response to opening of the reactor.

### Citation List

### [Patent Literatures]

[Patent Literature 1]
   US2012/0237678 (Publication date: September 20, 2012)
[Patent Literature 2]
   US2010/0043972 (Publication date: February 25, 2010)
[Patent Literature 3]
   WO2015/039841 (Publication date: March 26, 2015)

### Summary

### Technical Problem

During a process for growing polysilicon on the surface of a silicon core wire so that the resultant silicon rod has a diameter of approximately 100 mm to 200 mm, polysilicon may asymmetrically grow with respect to the center of the silicon core wire, depending on how to locate the silicon core wire on a bottom plate of a reactor. This causes the silicon rod to have a center of gravity that is deviated from the vertical direction extending from the center between electrodes that support the silicon rod. During deposition of polysilicon, the silicon rod, which has a temperature of 1000°C or more and which is ductile and softenable, can keep standing on its own even in a case where the center of gravity of the silicon rod is deviated from the vertical direction extending from the center of the electrodes.

However, the silicon rod whose temperature is decreased to 800°C or less while being cooled after the end of the reaction becomes neither ductile nor softenable. Thus, warpage occurs in the silicon rod which has the center of gravity that is deviated from the vertical direction extending from the center of the electrodes. The silicon rod in which warpage occurs falls over from its base in the reactor due to slight vibrations during and after the cooling, and in some cases may fall against an inner wall of a cover of the reactor.

In responding to such a phenomenon, the conventional techniques described earlier have the following problems. Patent Literatures 1 and 2 disclose the techniques for taking, out of a reactor, silicon rods that are standing upright in the reactor. It is therefore impossible to apply the techniques disclosed in Patent Literatures 1 and 2 to an operation to open the reactor by lifting the cover of the reactor in which the silicon rods have fallen against the inner wall of the cover of the reactor.

Further, in a case where the cover of the reactor is lifted in which the silicon rods have fallen against the inner wall of the cover of the reactor, the cover may laterally swing, while being lifted, due to the weight of the silicon rods that have fallen against the inner wall of the cover of the reactor. In this case, according to the technique disclosed in Patent Literature 3, the cover that is swinging laterally snags on the protective wall provided around the reactor, so that the cover can no longer be lifted. Thus, in order to lift the cover of the reactor while the silicon rods have fallen against the inner wall of the cover of the reactor, it is necessary to remove the protective wall. It is therefore also impossible to apply the technique disclosed in Patent Literature 3 to the operation to open the reactor by lifting the cover of the reactor in which the silicon rods have fallen against the inner wall of the cover.

The present invention has been made in light of the above-described conventional problems. An object of the present invention is to, even in a case where a silicon rod is in contact with an inner wall of a cover of a reactor, lift the cover so as to open the reactor.

### Solution to Problem

In order to solve the above problems, a rod-shaped body in accordance with an aspect of the present invention is a rod-shaped body to be used to lift a cover so as to detach the cover from a bottom plate, together with which the cover forms a reactor in which a silicon rod is contained upright, the rod-shaped body including: a first part to be inserted into a bottom plate-side hole provided in a surrounding area of the bottom plate; and a second part to be inserted into a cover-side hole provided in a surrounding area of the cover so as to face the bottom plate-side hole.

A detachment method in accordance with an aspect of the present invention is a method for detaching a cover from a bottom plate, together with which the cover forms a reactor in which a silicon rod is contained upright, the method including: a inserting step of inserting a rod-shaped body into a bottom plate-side hole provided in a surrounding area of the bottom plate and into a cover-side hole provided in a surrounding area of the cover so as to face the bottom plate-side hole; and a lifting step of lifting the cover while the rod-shaped body is inserted in the bottom plate-side hole and in the cover-side hole.

A method for manufacturing a silicon rod, in accordance with an aspect of the present invention, is a method for manufacturing a silicon rod, the method including a detaching step of detaching a cover from a bottom plate, together with which the cover forms a reactor in which a silicon rod is contained upright, the detaching step including: a inserting step of: inserting a rod-shaped body into a bottom plate-side hole provided in a surrounding area of a bottom plate that forms the reactor in which the silicon rod is contained and into a cover-side hole provided in a surrounding area of the cover so as to face the bottom plate-side hole; and a lifting step of lifting the cover while the rod-shaped body is inserted in the bottom plate-side hole and in the cover-side hole.

### Advantageous Effects of Invention

An aspect of the present invention makes it possible to, even in a case where a silicon rod is in contact with an inner wall of a reactor, lift a cover of the reactor so as to open the reactor.

### Brief Description of Drawings

- Fig. 1: is a side view illustrating how a cover of a reactor is detached from a bottom plate of the reactor while a rod-shaped body in accordance with an embodiment of the present invention is inserted in a bottom plate-side hole and in a cover-side hole.
- Fig. 2: is a cross-sectional view illustrating a state in which the rod-shaped body is inserted in the bottom plate-side hole and in the cover-side hole.
- Fig. 3: is a side view illustrating the reactor having a projection.
- Fig. 4: is a cross-sectional view describing Variation 1 of the embodiment of the present invention and schematically illustrating configurations of jigs of the rod-shaped body.
- Fig. 5: is a partial top view of the reactor illustrating a state in which the jig has been fitted to the cover of the reactor.
- Fig. 6: is a cross-sectional view describing Variation 2 of an embodiment of the present invention and illustrating a variation of the rod-shaped body.
- Fig. 7: is a side view illustrating how the cover of the reactor is detached from the bottom plate of the reactor while a protective structure in accordance with an embodiment of the present invention is provided around the reactor.
- Fig. 8: is a top view of the protective structure.

### Description of Embodiments

The following description will specifically discuss an embodiment of the present invention. For convenience of description, members having functions identical to those of the respective members described in variations of the embodiment are given respective reference signs, and a description of those members is omitted as appropriate. For convenience, the embodiment refers to a vertical direction assuming that a cover 103 side of a reactor 100 is an upper side and a bottom plate 101 side of the reactor 100 is a lower side. Note that the following description will refer to the vertical direction merely for convenience of description, and the present invention can be carried out in a direction that is not limited to the vertical direction.

### (Configuration of reactor)

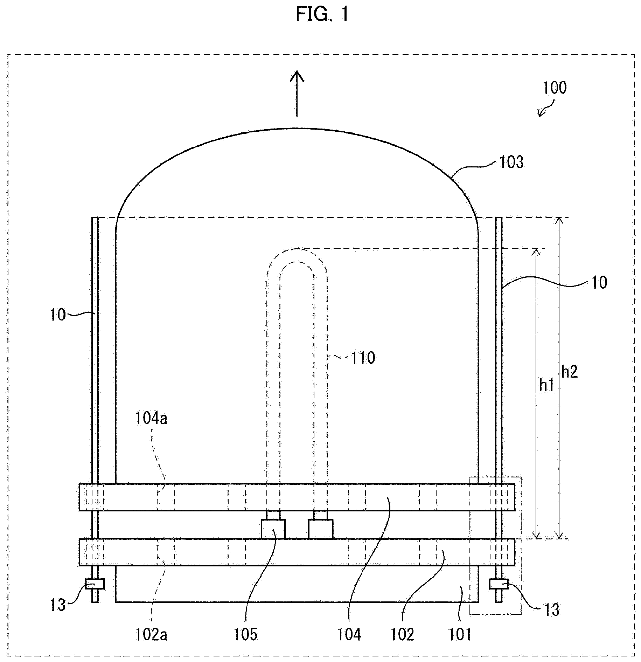

The following description will schematically discuss a configuration of the reactor 100 with reference to Fig. 1. Fig. 1 is a side view illustrating how a cover 103 of the reactor 100 is detached from a bottom plate 101 of the reactor 100 while a rod-shaped body 10 in accordance with Embodiment 1 of the present invention is inserted in a bottom plate-side hole 102a and in a cover-side hole 104a. The cover 103 of the reactor 100 illustrated in Fig. 1 has been slightly lifted above the bottom plate 101.

The reactor 100 is a device for forming silicon rods 110 by using a Siemens process to deposit polysilicon on silicon core wires placed inside the device. The reactor 100 includes the bottom plate 101 and the cover 103.

The bottom plate 101 is made of metal and is substantially circular. The bottom plate 101 has a bottom plate flange 102 which is provided so as to surround the bottom plate 101. The bottom plate flange 102 has a plurality of bottom plate-side holes 102a provided in a circumferential direction of the bottom plate 101 at substantially regular intervals. The bottom plate-side holes 102a are provided so as to vertically pass through the bottom plate flange 102. Further, many electrodes 105 on which silicon core wires are set upright are provided on the bottom plate 101. The silicon core wires are each typically formed in a U-shape by two vertical rods and one horizontal bridge rod, and are set upright on the electrodes 105 in an inverted U-shape so as to be perpendicular to the bottom plate 101. As described earlier, the silicon rods 110 are formed by depositing polysilicon on the silicon core wires. Fig. 1 illustrates only one set of a silicon rod 110 and an electrode 105 for simplification of the drawing.

The cover 103 is made of metal and has a bell shape. The cover 103 has a cover flange 104 which is provided in a lower part of the cover 103 so as to surround the cover 103. The cover flange 104 has a plurality of cover-side holes 104a provided in a circumferential direction of the cover 103 at substantially regular intervals. The cover-side holes 104a are provided so as to vertically pass through the cover flange 104 and located so as to face the respective bottom plate-side holes 102a.

Note that bolt holes originally provided in the bottom plate flange 102 and the cover flange 104 can be used as the bottom plate-side holes 102a and the cover-side holes 104a. This makes it unnecessary to carry out any step of additionally providing the bottom plate-side holes 102a in the bottom plate 101 or additionally providing the cover-side holes 104a in the cover 103. The reactor 100 can be sealed by (i) bringing the bottom plate 101 into contact with a lower end of the cover 103 so that the bolt holes provided in the bottom plate flange 102 face the respective bolt holes provided in the cover flange 104 and (ii) passing bolts through the bolt holes and tightening the bolts.

### (Rod-shaped body)

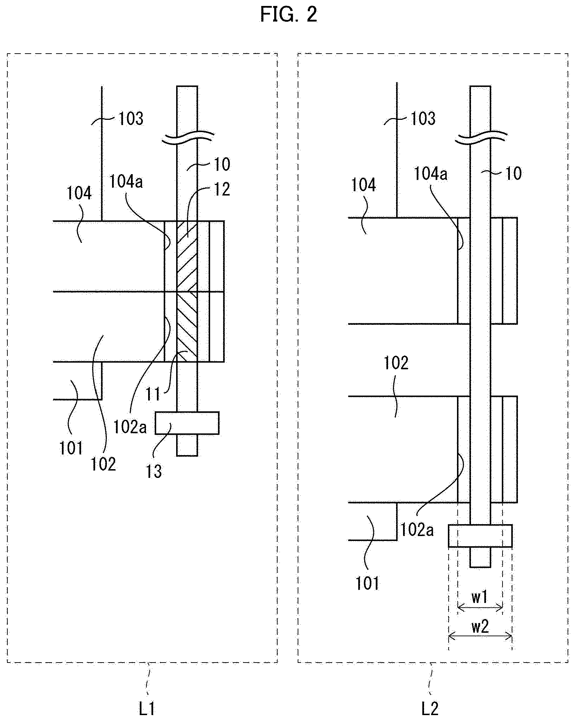

The following description will discuss the rod-shaped body 10 with reference to Figs. 1 and 2. Fig. 2 is a cross-sectional view that describes a part illustrated in Fig. 1 and enclosed by a chain double-dashed line and that illustrates a state in which the rod-shaped body 10 is inserted in a corresponding bottom plate-side hole 102a and in a corresponding cover-side hole 104a. In Fig. 2, a diagram enclosed by a dotted line L1 illustrates a state in which the cover 103 has not been lifted, and a diagram enclosed by a dotted line L2 illustrates a state in which the cover 103 has been lifted slightly above the bottom plate 101. The rod-shaped body 10 (all fall guide) is used to lift the cover 103 so as to detach the cover 103 from the bottom plate 101, together with which the cover 103 forms the reactor 100 in which the silicon rod 110 is contained upright.

As illustrated in L1 of Fig. 2, the rod-shaped body 10 includes: a first part 11 to be inserted into the bottom plate-side hole 102a provided in a surrounding area of the bottom plate 101; and a second part 12 to be inserted into the cover-side hole 104a provided in a surrounding area of the cover 103 so as to face the bottom plate-side hole 102a. The rod-shaped body 10 includes a nonslip part 13 that is removably provided so as to be closer to a lower end of the rod-shaped body 10 than is the first part 11 and that extends in an axial direction of the rod-shaped body 10 so as to surround the rod-shaped body 10. As illustrated in L2 of Fig. 2, the nonslip part 13 has a length w2 that is measured in a radial direction of the rod-shaped body 10 and is greater than a diameter w1 of the bottom plate-side hole 102a.

In addition, as illustrated in Fig. 1, a height h2 from the bottom plate 101 to an upper end of the rod-shaped body 10 as measured in a state in which the rod-shaped body 10 is inserted in the bottom plate-side hole 102a and in the cover-side hole 104a is preferably greater than a height h1 from the bottom plate 101 to an upper end of the silicon rod 110 that stands upright. In particular, the height h2 is preferably 200 mm to 500 mm greater than the height h1.

### (Method for detaching cover)

The following description will discuss an example of a method for detaching the cover 103 from the bottom plate 101, together with which the cover 103 forms the reactor 100 in which the silicon rod 110 is contained upright.

First, the rod-shaped body 10 is inserted into the bottom plate-side hole 102a provided in the surrounding area of the bottom plate 101 and into the cover-side hole 104a provided in the surrounding area of the cover 103 so as to face the bottom plate-side hole 102a (an inserting step). In this inserting step, the rod-shaped body 10 is passed through the bottom plate-side hole 102a and the cover-side hole 104a while no nonslip part 13 is fitted to the rod-shaped body 10 at a position that is closer to the lower end of the rod-shaped body 10 than is the first part 11. The nonslip part 13 is fitted to the rod-shaped body 10 after the rod-shaped body 10 is passed through the bottom plate-side holes 102a and the cover-side holes 104a. Further, the rod-shaped body 10 that has been inserted into the surrounding area of the bottom plate 101 and into the surrounding area of the cover 103 in the inserting step includes two or more rod-shaped bodies 10 that are inserted at respective places at substantially regular intervals in the circumferential direction of the bottom plate 101 and of the cover 103. Typically six, preferably three, and particularly preferably two rod-shaped bodies 10 are to be inserted. For example, in a case where two rod-shaped bodies 10 are inserted, the rod-shaped bodies 10 are inserted in the bottom plate-side holes 102a located at respective both ends of the diameter of the reactor 100 and in the cover-side holes 104a located at respective both ends of the diameter of the reactor 100.

Next, the cover 103 is lifted upward (in the direction indicated by the arrow in Fig. 1) while the rod-shaped bodies 10 are inserted in the bottom plate-side holes 102a and in the cover-side holes 104a (lifting step).

The cover 103 that is being lifted unfortunately may laterally swing due to the weight of the silicon rods having fallen against an inner wall of the cover 103. Specifically, such a lateral swing of the cover 103 causes, for example, (1) a problem such that the cover 103 hits the silicon rod 110 that stands upright in the reactor 100, and the silicon rod 110 falls over accordingly, or (2) a problem such that the cover 103 hits a protective wall provided around the reactor 100, so that the cover 103 can no longer be lifted.

However, the cover 103 is lifted along the rod-shaped bodies 10 by being lifted while the rod-shaped bodies 10 are inserted in the bottom plate-side holes 102a and in the cover-side holes 104a. This makes it possible to substantially vertically lift the cover 103. Consequently, even in a case where the silicon rod 110 is in contact with an inner wall of the reactor 100, the cover 103 can be prevented from laterally swinging while being lifted, and can be lifted to a position higher than an upper end of the silicon rod 110 that stands upright on the bottom plate 101.

In a case where a method for manufacturing the silicon rod 110 includes the inserting step and the lifting step as the step of detaching the cover 103 which forms the reactor 100 together with the bottom plate 101, it is possible to achieve a method for manufacturing the silicon rod 110, the method bringing about the following effect. Specifically, it is possible to achieve a method for manufacturing the silicon rod 110, the method making it possible to, even in a case where the silicon rod 110 is in contact with the inner wall of the reactor 100, open the reactor 100 by lifting the cover 103.

### (Design of rod-shaped body)

The inventor has conducted various analyses of a rod-shaped body 10 and found that the lateral swing of the cover 103 which is being lifted can be optimally prevented by designing the rod-shaped body 10 on the basis of the following description.

Specifically, the rod-shaped body 10 desirably has a diameter that is 85% to 98%, preferably 90% to 95%, and particularly preferably 92% to 94% of the diameter of a bottom plate-side hole 102a and a cover-side hole 104a. When a ratio of the diameter of the rod-shaped body 10 to the diameter of the bottom plate-side hole 102a and the cover-side hole 104a is too large, the rod-shaped body 10 gets stuck in the bottom plate-side hole 102a and in the cover-side hole 104a. This makes it impossible to smoothly pass the rod-shaped body 10 through the bottom plate-side hole 102a and the cover-side hole 104a, and further makes it impossible to smoothly lift the cover 103. When the ratio of the diameter of the rod-shaped body 10 to the diameter of the bottom plate-side hole 102a and the cover-side hole 104a is too small, the cover 103 swings laterally in a range equal to or greater than an allowable range and, moreover, the rod-shaped body 10 decreases in strength.

The rod-shaped body 10 can have a diameter that is not limited to the above diameter and is not limited to any particular dimeter, provided that a lower surface of the cover flange 104 laterally swings in a range of -100 mm to +100 mm, preferably -70 mm to +70 mm, and particularly preferably -40 mm to +40 mm, relative to an upper surface of the bottom plate flange 102. In the reactor 100 in which several tens of silicon core wires are set upright on the bottom plate 101 so that several tens of silicon rods 110 are grown, many silicon core wires are set upright on many concentric circles so as to be grown. A silicon rod 110 into which a silicon core wire standing on a circumference of one of the concentric circles which one is the closest to the cover 103 has grown so as to have a diameter of 100 mm to 200 mm is at a distance of typically approximately several hundred millimeters from the inner wall of the cover 103. In view of this, the cover 103 is required to laterally swing in the range of -100 mm to +100 mm so that the cover 103 will not come into contact with the silicon rod 110.

Further, in considering bending of the rod-shaped body 10, the rod-shaped body 10 desirably has a diameter of 10 mm to 50 mm, preferably 15 mm to 45 mm, and particularly preferably 20 mm to 40 mm. The rod-shaped body 10 that has a diameter of less than 10 mm greatly bends, so that the cover 103 laterally swings more widely while being lifted. The rod-shaped body 10 that has a diameter of more than 50 mm becomes heavier. This results in lower workability. The rod-shaped body 10 can have a length that is not limited to any particular length, provided that the length makes it possible to lift the cover 103 to a position higher than the upper end of the silicon rod 110 that has grown in the reactor 100. As described earlier, the height h2 from the bottom plate 101 to the upper end of the rod-shaped body 10 is preferably 200 mm to 500 mm greater than the height h1 from the bottom plate 101 to the upper end of the silicon rod 110 that stands upright from the bottom plate 101. The rod-shaped body 10 typically has a length of 500 mm to 3000 mm.

### (Variation 1)

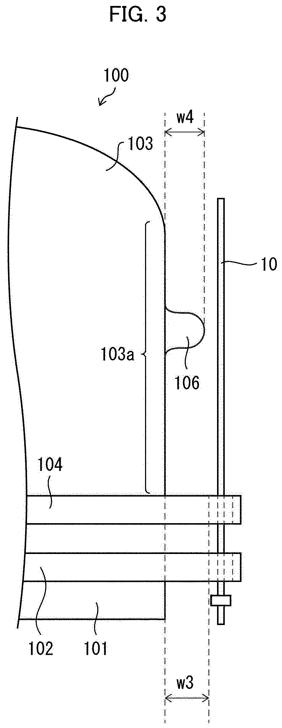

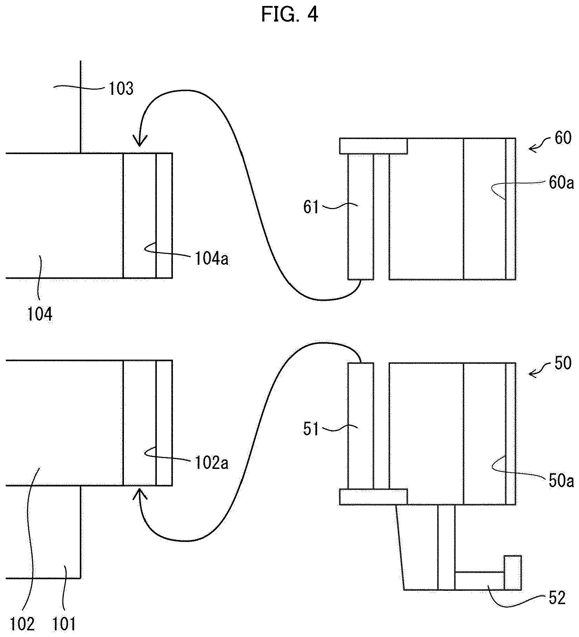

The following description will discuss Variation 1 of the present invention with reference to Figs. 3 and 4. Fig. 3 is a side view illustrating the reactor 100 having a projection 106. Fig. 4 is a cross-sectional view describing Variation 1 of the present invention and schematically illustrating configurations of jigs 50 and 60 of the rod-shaped body 10.

The cover 103 of the reactor 100 can have various shapes. For example, the cover 103 may have the projection 106 provided on a side-wall surface 103a (an outer wall) of the cover 103 (see Fig. 3). The projection 106 serves as, for example, a projecting structure such as a nozzle and an inspection manhole.

Even in a case where the projection 106 is provided on the cover 103, there is no problem provided that a distance w3 is longer than a distance w4 as illustrated in Fig. 3. The distance w3 is a distance from an outer edge of the bottom plate 101 to the bottom plate-side hole 102a, and is also a distance from the outer wall of the cover 103 to the cover-side hole 104a. The distance w4 is a distance from the outer wall of the cover 103 to an end of the projection 106 provided on the outer wall of the cover 103, the end facing away from the outer wall of the cover 103.

However, in a case where the distance w3 is shorter than the distance w4 and the rod-shaped body 10 is to be passed through the bottom plate-side hole 102a provided in the bottom plate flange 102 and through the cover-side hole 104a provided in the cover flange 104, the rod-shaped body 10 bumps against the projection 106 depending on where the projection 106 is provided. In that case, it is impossible to insert the rod-shaped body 10 into the bottom plate-side hole 102a and into the cover-side hole 104a. This makes it impossible to vertically lift the cover 103. For this reason, the jigs 50 and 60 are used in a case where the projection 106 is provided on the cover 103 and the distance w3 is shorter than the distance w4.

As illustrated in Fig. 4, in order to provide, in the surrounding area of the bottom plate 101, the bottom plate-side hole 102a into which the rod-shaped body 10 is to be inserted, the jig 50 includes an attachment part 51 to be attached in the surrounding area of the bottom plate 101, and has a hole 50a formed therein that serves as the bottom plate-side hole 102a. The jig 50 also includes a supporting part 52, provided in a lower part of the jig 50, for supporting a lower end part of the rod-shaped body 10. In using the jig 50, the jig 50 is fitted to the bottom plate flange 102 by inserting, from below, the attachment part 51 into the bottom plate-side hole 102a formed in the bottom plate flange 102, and the first part 11 of the rod-shaped body 10 is inserted in the hole 50a serving as the bottom plate-side hole 102a.

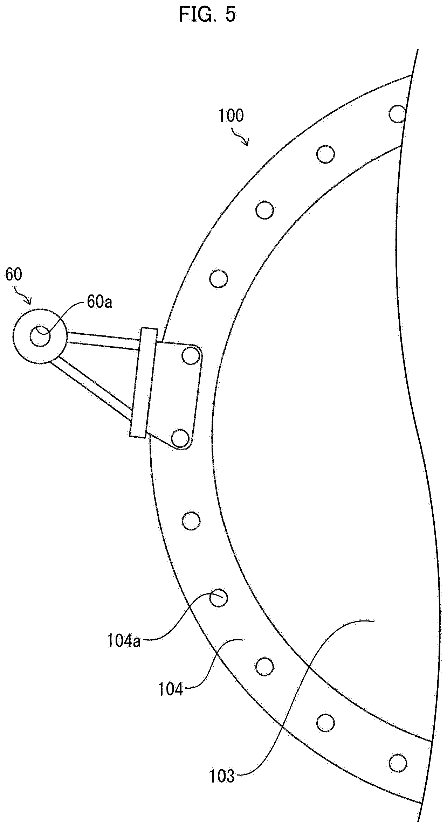

In order to provide, in the surrounding area of the cover 103, the cover-side hole 104a into which the rod-shaped body 10 is to be inserted, the jig 60 includes an attachment part 61 to be attached in the surrounding area of the cover 103, and has a hole 60a formed therein that serves as the cover-side hole 104a. In using the jig 60, the jig 60 is fitted to the cover flange 104 by inserting, from above, the attachment part 61 into the cover-side hole 104a formed in the cover flange 104, and the second part 12 of the rod-shaped body 10 is inserted into the hole 60a serving as the cover-side hole 104a. Fig. 5 illustrates an example of how the jig 60 has been fitted. Fig. 5 is a partial top view of the reactor 100 and illustrates a state in which the jig 60 has been fitted to the cover flange 104 of the reactor 100.

When the jigs 50 and 60 are used, a distance from the outer edge of the bottom plate 101 to the hole 50a serving as the bottom plate-side hole 102a and a distance from the outer wall of the cover 103 to the hole 60a serving as the cover-side hole 104a are each longer than a distance from the outer wall of the cover 103 to an end of the projection 106 provided on the outer wall of the cover 103, the end facing away from the outer wall of the cover 103. Thus, in a case where the jigs 50 and 60 are used, the rod-shaped body 10 can be disposed so as not to bump against the projection 106 and so as to be substantially parallel to the side-wall surface 103a of the cover 103 and substantially vertically extend. This makes it possible to lift the cover 103 above the upper end of the silicon rod 110.

Note that a ratio of the diameter of the rod-shaped body 10 to the diameter of the hole 50a serving as the bottom plate-side hole 102a and the hole 60a serving as the cover-side hole 104a is designed so as to be similar to a ratio of the diameter of the rod-shaped body 10 to the diameter of the bottom plate-side hole 102a and the cover-side hole 104a.

### (Variation 2)

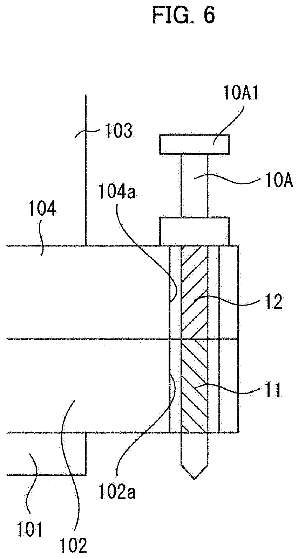

The following description will discuss Variation 2 of the present invention with reference to Fig. 6. Fig. 6 is a cross-sectional view describing Variation 2 of an embodiment of the present invention and illustrating a state in which a rod-shaped body 10A, which is a variation of the rod-shaped body 10, is inserted in the bottom plate-side hole 102a and in the cover-side hole 104a.

In the step of lifting the cover 103, it is possible to use the rod-shaped body 10 whose length and thickness are changed depending on a lifted state of the cover 103. Specifically, it is possible to prepare a shorter rod-shaped body (the rod-shaped body 10A) having a shorter length than a longer rod-shaped body (the rod-shaped body 10) that has been described with reference to Fig. 1 and designed such that the height h2 from the bottom plate 101 to the upper end of the rod-shaped body 10 is greater than the height h1 from the bottom plate 101 to the upper end of the silicon rod 110 standing upright. One of the shorter and longer rod-shaped bodies can be selectively used, or both the shorter and longer rod-shaped bodies can be simultaneously used.

More specifically, while the bolts that fix the bottom plate flange 102 and the cover flange 104 are being removed so that the cover 103 is detached from the bottom plate 101, the bottom plate 101 and the cover 103 are more likely to be positionally displaced from each other in the reactor 100. Further, the bottom plate flange 102 and the cover flange 104 may partially strongly adhere to each other during the detachment of the cover 103 from the bottom plate 101. In such a case, it may be necessary to apply a heavy load in order to separate the cover flange 104 from the bottom plate flange 102. In addition, at the beginning of the lifting of the cover 103, a load caused by the swing is particularly high. For these reasons, it is necessary to particularly increase positional stability of the cover 103 during a period from the detachment of the bolts to the beginning of the lifting of the cover 103. This leads to a desirable aspect in which such a shorter rod-shaped body 10A and the longer rod-shaped body are selectively used, or simultaneously used.

The rod-shaped body 10A is desirably thick and short. Specifically, the rod-shaped body 10A has a length of, for example, 300 mm to 400 mm. The rod-shaped body 10A desirably has a diameter in a range of 92% to 97%, which is the particularly preferable range among the above-described ranges of the diameter relative to the diameter of the bottom plate-side hole 102a and the cover-side hole 104a. The diameter of the rod-shaped body 10A is desirably 20 mm to 30 mm in actual size. The rod-shaped body 10A is provided with a handle 10A1 which is closer to an upper end of the rod-shaped body 10A than is the second part 12 and which extends in an axial direction of the rod-shaped body 10A so as to surround the rod-shaped body 10A (see Fig. 6). The rod-shaped body 10A is used to increase the positional stability during the period from the detachment of the bolts to the beginning of the lifting of the cover 103. This eliminates the need to necessarily provide the nonslip part 13, which is provided so as to be closer to the lower end of the rod-shaped body 10 than is the first part 11. Further, in order to carry out an operation while the cover 103 is being lifted approximately one meter, it is possible to use a longer rod-shaped body (not illustrated) than the rod-shaped body 10A.

### (Protective structure)

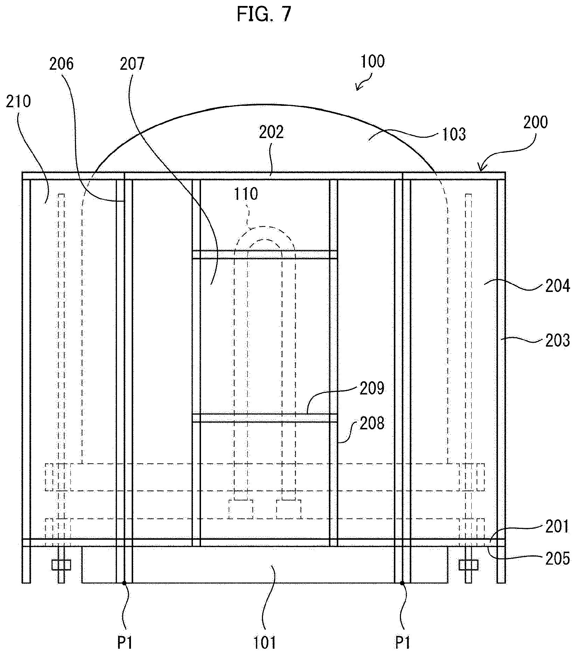

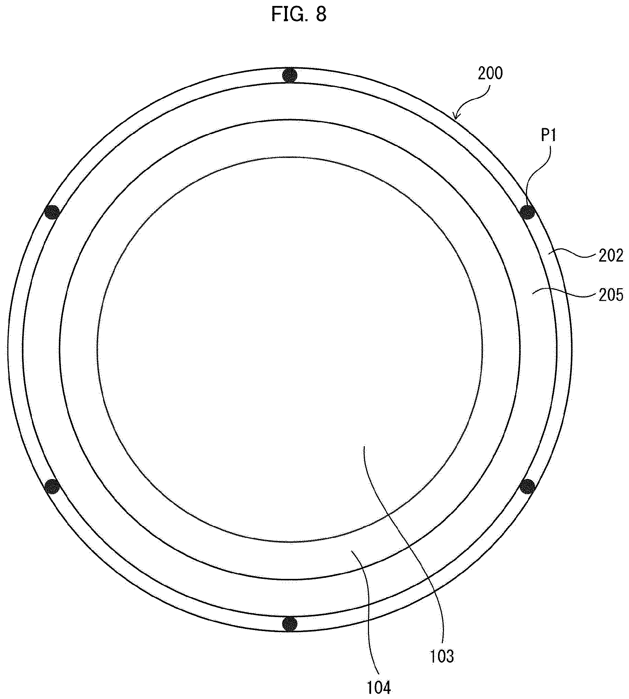

The following description will discuss a protective structure 200 with reference to Figs. 7 and 8. Fig. 7 is a side view illustrating how the cover 103 of the reactor 100 is detached from the bottom plate 101 of the reactor 100 while the protective structure 200 in accordance with an embodiment of the present invention is provided around the reactor 100. Fig. 8 is a top view of the protective structure 200.

The protective structure 200 is a structure for preventing, during the detachment of the cover 103 from the bottom plate 101, silicon rods 110 standing upright on the bottom plate 101 from falling over outside the bottom plate 101 and being scattered over a floor. The protective structure 200 is provided around the reactor 100. It is possible to provide the protective structure 200 around the reactor 100 in order to only lift the cover 103 against which the silicon rods 110 have fallen. The protective structure 200 includes a first frame body 201 (frame body), a second frame body 202, a plurality of third frame bodies 203, and a protective wall surface 204 (see Figs. 7 and 8).

The first frame body 201 is shaped so as to surround the bottom plate 101 of the reactor 100 in which the silicon rods 110 are contained. The first frame body 201 is connected to the plurality of third frame bodies 203 extending vertically. The first frame body 201 is supported by the plurality of third frame bodies 203 at a position at which the first frame body 201 surrounds the bottom plate 101.

The second frame body 202 extends horizontally and is connected to upper ends of the plurality of third frame bodies 203. The second frame body 202 is supported by the plurality of third frame bodies 203 so as to extend horizontally. Each of the plurality of third frame bodies 203 is connected to the first frame body 201 and the second frame body 202, and supports the first frame body 201 and the second frame body 202.

The protective wall surface 204 extends vertically upward from the first frame body 201 and forms a storage space 210 for the silicon rods 110. The protective wall surface 204 has a mesh structure.

The protective structure 200 includes a protective plate 205 having a ring shape and provided between the first frame body 201 and the bottom plate 101 of the reactor 100. The protective plate 205 has a flat surface that extends so as to surround the bottom plate 101 and that spreads horizontally. The protective plate 205 is provided, for example, so as to be level with a lower surface of the bottom plate flange 102 of the reactor 100. Since the protective plate 205 is thus provided between the bottom plate 101 and the first frame body 201, the silicon rods 110 that have fallen over are scattered over the protective plate 205. This allows the protective structure 200 for the silicon rods 110 to prevent the silicon rods 110 from being scattered over the floor.

The protective wall surface 204 includes a takeout window 207 formed therein for taking out the silicon rods 110 that are contained in the reactor 100. The takeout window 207 is formed by being surrounded by two fourth frame bodies 208 and two fifth frame bodies 209. The fourth frame bodies 208 extend vertically and are provided between the first frame body 201 and the second frame body 202. The fifth frame bodies 209 extend horizontally and are provided between the two fourth frame bodies 208. By thus forming the takeout window 207 in the protective wall surface 204, it is possible to take out the silicon rods 110 through the takeout window 207 while the protective structure 200 for the silicon rods 110 is provided without being disassembled.

The protective structure 200 can be divided along dividing lines 206 each extending vertically upward from a corresponding one of a plurality of points P1 on the first frame body 201. That is, the protective structure 200 as illustrated in Fig. 8 can be divided into six parts. This makes it possible to efficiently assemble the protective structure 200 by, for example, dividing the protective structure 200 for the silicon rods 110 into parts having sizes suitable for transportation and storage of the silicon rods 110.

The above configuration allows the protective wall surface 204 to have a mesh structure in the protective structure 200 for the silicon rods 110, the protective wall surface 204 extending vertically upward from the first frame body 201 and forming the storage space for the silicon rods 110. Thus, according to the protective structure 200 for the silicon rods 110, it is possible to achieve visibility from outside to inside the protective structure 200 while preventing the silicon rods 110 from being scattered outside the protective structure 200 for the silicon rods 110. As a result, the protective structure 200 for the silicon rods 110 makes it possible to, for example, while checking how the silicon rods 110 have fallen over, carry out an operation to lift the cover 103 of the reactor 100.

### (Design of protective structure)

The silicon rods 110, each of which is several meters high and weighs several tens of kilograms, are easily broken even by a small impact. Due to an impact caused when the silicon rods 110 begin to fall toward the outside of the reactor 100 during the lifting of the cover 103 or an impact caused when the silicon rods fall over, the silicon rod 110 are broken into pieces of silicon in massive or powdery form that are widely distributed in terms of size. Almost all of these pieces of silicon need to be captured.

The inventor has conducted various analyses and found that by lifting the cover 103 while the protective structure 200 that meets design requirements described below is provided around the reactor 100, it is possible to cause the protective structure 200 to receive (i) the silicon rods 110 having fallen over and (ii) pieces into which the silicon rods 110 have been broken.

### (Design of protective wall surface)

The silicon rods 110 that have grown typically have a U-shape and have a length of four meters to six meters in terms of a linear length and have a thickness of 100 mm to 200 mm. Assuming that the specific gravity of silicon is 2.4 g/cm³, a single silicon rod 110 has a weight of 75 kg to 460 kg, and the silicon rods 110 have a total weight of 1300 kg to 8200 kg in the reactor 100 for 18 U-shaped rods. Thus, the protective structure 200 that does not have a sufficient strength may cause the silicon rods 110 and fragments produced when the silicon rods 110 are broken to crash through the protective structure 200 and may harm a worker who carries out an operation to open the reactor.

Note here that as a result of observation of a manner in which the silicon rods 110 start to fall over, the inventor has found that the silicon rods 110 are scattered inside the protective structure 200 in the following manner. Specifically, each of the silicon rods 110 (1) slowly falls toward the outside of the reactor 100 from joints between a silicon rod 110 and corresponding electrodes 105, (2) slowly leans against the protective structure 200 and remains in a rod form or is broken up due to an impact caused by its falling against the protective structure 200, and (3) is divided into silicon blocks and/or silicon pieces and is scattered inside the protective structure 200.

The above manner shows that a static pressure applied on a point A (not illustrated) in an inner surface of the protective pressure 200 when all the silicon rods 110 on the reactor 100 lean against the protective structure 200 depends on a distance L between the bottom plate flange 102 and the protective structure 200 and a weight W of all of the silicon rods 110 inside the reactor 100. That is, the magnitude of the static pressure can be estimated by setting respective values of the distance L and the weight W. For example, in a case where the protective wall surface 204 of the protective structure 200 is placed within 1 m from an outer diameter of the bottom plate flange 102 of the reactor 100, the static pressure that is applied to the protective wall surface 204 of the protective structure 200 is lower than or equal to half the total weight of the silicon rods 110.

### (Mesh of protective wall surface)

In terms of achievement of higher work efficiency, the protective wall surface 204 is preferably made of metal and preferably has a mesh structure. This is because the protective wall surface 204 that is lighter further facilitates an operation to place the protective wall surface 204. In order to make the protective structure 200 lighter, it is desirable to set a mesh size of the protective wall surface 204 as below. Specifically, a test of breaking up the silicon rods 110 that have grown is carried out, a size distribution of silicon pieces produced due to the breakup of the silicon rods 110 is found, and a mesh size that enables not less than 99% of the silicon pieces to be captured is set as the mesh size of the protective wall surface 204. The protective wall surface 204 that has a too small mesh size causes the inside of the protective structure 200 to be less visible from the outside of the protective structure 200. Specifically, the protective wall surface 204 desirably has an optimal mesh size of 2 mesh to 10 mesh, preferably 3 mesh to 7 mesh, and particularly preferably 3 mesh to 5 mesh.

Further, it is desirable to determine the gauge of a wire mesh gauze of the protective structure 200 on the basis of the static pressure described above. Specifically, the wire gauze of the protective wall surface 204 desirably has 16 gauge to 20 gauge, preferably 17 gauge to 19 gauge, and particularly preferably 18 gauge. This configuration makes it possible to accept the static pressure caused by the fall of the silicon rods 110.

### (Design of division)

It is determined only through an inspection window (not illustrated) provided in the side-wall surface 103a of the cover 103 or through a space created by slightly lifting the cover 103 whether the silicon rods 110 obtained through deposition have fallen against the inner wall of the cover 103. Thus, in a case where it is determined that the silicon rods 110 have fallen against the inner wall of the cover 103, it is necessary to stop lifting the cover 103 and to quickly assemble the protective structure 200. This requires an operation to assemble the protective structure 200 to be quickly carried out.

The protective structure 200 that is structured to be divided makes even lighter individual parts into which the protective structure 200 is divided and facilitates an operation to place the protective structure 200. In a case where the protective structure 200 is structured to be divided so as to be more mobile, the number of parts into which the protective structure 200 is divided is desirably selected on the basis of weights that allow manual transportation. Specifically, the number of the parts into which the protective structure 200 is divided is desirably determined such that each of the parts into which the protective structure 200 is divided has a weight of 80 kg to 180 kg, preferably 100 kg to 160 kg, and particularly preferably 120 kg to 150 kg.

The following description will discuss an example of assembly of the protective structure 200 that is structured to be divided. The parts into which the protective structure 200 is divided are placed in close contact with each other so as to surround the reactor 100 in the form of a ring. Then, joints of adjacent ones of the parts into which the protective structure 200 is divided are fixed by quick coupling so that the protective structure 200 into which the parts are integrated is assembled.

### (Design of first frame body)

The first frame body 201 of the protective structure 200 forms a circle which can have any diameter provided that the diameter is larger than the outer diameter of the bottom plate flange 102 and the cover flange 104 of the reactor 100. Specifically, the circle formed by the first frame body 201 desirably has a diameter that is 0 mm to 1000 mm, preferably by 200 mm to 700 mm, and particularly preferably by 300 mm to 600 mm larger than the outer diameter of the bottom plate flange 102 and the cover flange 104. This makes it possible to smoothly lift the cover 103 inside the protective structure 200 and to allow a lower static pressure to be applied to the protective wall surface 204 by the silicon rods 110 having fallen against the protective wall surface 204.

The silicon rods 110 that have been broken up due to an impact of their falling against the protective structure 200 are divided into silicon blocks and/or silicon pieces, and are scattered inside the protective structure 200. The inventor has found that some silicon blocks and/or silicon pieces jump over the protective structure 200 depending on the particle diameter of the silicon pieces produced or the height of the protective structure 200.

Under the circumstances, the inventor measured a size distribution of silicon blocks and/or silicon pieces each produced due to an impact of collapse of the silicon rods 110. Results of the measurement have turned out that silicon pieces which are produced in a case where the silicon rods 110 having a length of several meters and having a diameter of 100 mm to 200 mm are collapsed and broken have a minimum size of not less than approximately 10 mm. In order to receive all the silicon rods 110 that are thus scattered, it is desirable to design the first frame body 201 such that a distance from the inner surface of the protective structure 200 to the outer surface of the reactor 100 is 500 mm, preferably 300 mm, and particularly preferably 250 mm.

### (Height of protective structure)

The protective structure 200 can have any height provided that the height is greater than a height H (not illustrated) from a floor of a reactor chamber in which the reactor 100 is placed to upper ends of the silicon rods 110 that stand upright on the bottom plate 101 without being collapsed. The protective structure 200 that has a height much greater than the height H is not preferable. This is because the protective structure 200 thus configured makes it necessary to lift the silicon rods 110 too high in order to take out the silicon rods 110 inside the protective structure 200 by moving the silicon rods 110 above the protective structure 200. This makes workability worse.

In contrast, the protective structure 200 that has a height much smaller than the height H makes it impossible to, when the silicon rods 110 fall over toward the outside the reactor 100, prevent silicon pieces that are produced due to collapse of the silicon rods 110 from jumping over the protective structure 200. The protective structure 200 therefore desirably has a height that is -200 mm to 800 mm, preferably 0 mm to 500 mm, and particularly preferably 0 mm to 200 mm greater than the height H.

### (Method for evaluating distribution of silicon pieces)

The distribution of silicon pieces produced due to the breakup of the silicon rods 110 was evaluated as below. The silicon rods 110 that were not collapsed in the reactor and then successfully taken out of the reactor 100 were set upright on a flat floor. These silicon rods 110 were caused to fall from lower ends of the silicon rods 110. Silicon pieces produced due to such collapse of the silicon rods 110 as described above were subjected to a measurement of the weight distribution of sizes thereof. In order that the silicon rods 110 having fallen over would not directly contact a surface of the floor, other silicon rods 110 different from the silicon rods 110 to be caused to fall on the flat floor were caused to lie sideway and densely placed so as to surround the silicon rods 110 to be caused to fall.

### (Method for manufacturing silicon rod with use of protective structure)

The following description will discuss an example of a method for manufacturing a silicon rod with use of the protective structure 200. First, the bottom plate flange 102 and the cover flange 104 of the reactor 100 are unbolted after deposition of the silicon rods 110 is ended. Subsequently, the rod-shaped body 10 is inserted into the bottom plate-side hole 102a provided in the surrounding area of the bottom plate 101 and into the cover-side hole 104a provided in the surrounding area of the cover 103 so as to face the bottom plate-side hole 102a.

Next, it is checked whether the silicon rods 110 have fallen against the inner wall of the cover 103. In a case where the silicon rods 110 have fallen against the inner wall of the cover 103, the protective structure 200 is provided around the reactor 100 so that the storage space 210 for the silicon rods 110 is formed. The protective structure 200 includes the first frame body 201 that is shaped so as to surround the bottom plate 101 and the protective wall surface 204 that extends vertically upward from the first frame body 201 and that has a mesh structure. Subsequently, the cover 103 is lifted upward while the rod-shaped body 10 is inserted in the bottom plate-side hole 102a and in the cover-side hole 104a.

With the configuration, in order to lift the cover 103 having an inner wall against which the silicon rods 110 have fallen, it is possible to lift the cover 103 substantially without causing the cover 103 to laterally swing. It is therefore possible to prevent snagging of the cover 103 on the protective structure 200 due to the lateral swing. Thus, even in a case where the silicon rods 110 have fallen against the inner wall of the cover 103, an operation to lift the cover 103 can be carried out while the protective structure 200 is provided around the reactor 100. As a result, the operation to lift the cover 103 can be carried out while the silicon rods 110 are prevented from being scattered outside the protective structure 200.

Since it is possible to lift the cover 103 substantially without causing the cover 103 to laterally swing, it is possible to prevent the silicon rods 110 inside the bottom plate 101 from falling like dominos. Furthermore, without a reduction in yield of the silicon rods 110, it is possible to prevent silicon pieces produced due to the breakup of the silicon rods 110 from being scattered on the floor of the reaction chamber. This avoids a risk to a worker who carries out an operation to open the cover 103. Furthermore, the operation to open the cover 103 can be finished in a short time, and a subsequent deposition reaction can be immediately carried out. This enhances productivity.

Aspects of the present invention can also be expressed as follows:
A rod-shaped body in accordance with an aspect of the present invention is a rod-shaped body to be used to lift a cover so as to detach the cover from a bottom plate, together with which the cover forms a reactor in which a silicon rod is contained upright, the rod-shaped body including: a first part to be inserted into a bottom plate-side hole provided in a surrounding area of the bottom plate; and a second part to be inserted into a cover-side hole provided in a surrounding area of the cover so as to face the bottom plate-side hole.

According to this configuration, when the cover is detached from the bottom plate, the cover is lifted from the bottom plate while the first part of the rod-shaped body is inserted in the bottom plate-side hole provided in the surrounding area of the bottom plate and the second part of the rod-shaped body is inserted in the cover-side hole provided in the surrounding area of the cover so as to face the bottom plate-side hole. As such, the cover is lifted along the rod-shaped body and is therefore substantially vertically lifted. As a result, even in a case where the silicon rod is in contact with an inner wall of the reactor, it is possible to prevent the cover from laterally swinging during the lifting of the cover and to lift the cover to open the reactor.

This makes it possible to prevent the silicon rods contained upright in the reactor from falling like dominos due to the lateral swing of the cover and therefore increase the yield rate of the silicon rods. Furthermore, an operation to open the reactor can be finished in a short time, and a subsequent deposition reaction can be immediately carried out. This enhances productivity.

A jig in accordance with an aspect of the present invention can include an attachment part to be attached in a surrounding area of the bottom plate so that the bottom plate-side hole into which the rod-shaped body is to be inserted is provided in the surrounding area of the bottom plate; the jig having a hole formed therein that serves as the bottom plate-side hole.

This configuration make it possible to provide, with use of the jig, a hole serving as the bottom plate-side hole in the surrounding area of the bottom plate, by attaching the attachment part in the surrounding area of the bottom plate even in the absence of an appropriate bottom plate-side hole in the surrounding area of the bottom plate.

The jig can further include a supporting part, provided in a lower part of the jig, for supporting a lower end part of the rod-shaped body.

According to this configuration, when the rod-shaped body is inserted into the jig, the supporting part supports the lower end part of the rod-shaped body. This makes it possible to prevent the rod-shaped body from dropping from the jig and keep the rod-shaped body inserted.

The jig can also include an attachment part to be attached in a surrounding area of the cover so that the cover-side hole into which the rod-shaped body is to be inserted is provided in the surrounding area of the cover, the jig having a hole formed therein that serves as the cover-side hole.

This configuration makes it possible to provide, with use of the jig, a hole serving as the cover-side hole in the surrounding area of the cover, by attaching the attachment part in the surrounding area of the cover even in the absence of an appropriate cover-side hole in the surrounding area of the cover.

Further, the first part of the rod-shaped body can be inserted into the bottom plate-side hole that is formed in a flange provided to the bottom plate and the second part of the rod-shaped body can be inserted into the cover-side hole that is formed in a flange provided to the cover.

According to this configuration, the bottom plate-side hole and the cover-side hole are formed in the respective flanges. This makes it possible to insert the rod-shaped body in the bottom plate-side hole and in the cover-side hole without adding a new configuration to the reactor.

According to the rod-shaped body, a distance from an outer edge of the bottom plate to the bottom plate-side hole and a distance from an outer wall of the cover to the cover-side hole can each be greater than a distance from the outer wall of the cover to an end of a projection provided on the outer wall of the cover, the end facing away from the outer wall of the cover.

According to this configuration, the bottom plate-side hole and the cover-side hole are formed to be further on the outer side of the cover than is the projection provided on the outer wall of the cover. Accordingly, when the rod-shaped body is inserted in the bottom plate-side hole and in the cover-side hole, the projection and the rod-shaped body do not come into contact with each other. It is therefore possible to insert the rod-shaped body in the bottom plate-side hole and in the cover-side hole even in a case where the projection is provided on the outer wall of the cover.

According to the rod-shaped body, in a case where the rod-shaped body is inserted in the bottom plate-side hole and in the cover-side hole, a height from the bottom plate to an upper end of the rod-shaped body can be greater than a height from the bottom plate to an upper end of the silicon rod standing upright on the bottom plate.

This configuration makes it possible to, even in a case where the silicon rod falls toward the inner wall of the cover inside the reactor, substantially vertically lift the cover until the upper end of the silicon rod is exposed. Consequently, even in a case where the silicon rod falls over inside the reactor, it is possible to lift the cover to a position higher than an upper end of the silicon rod while the cover is kept prevented from laterally swinging.

The rod-shaped body can include a nonslip part which is removably provided so as to be closer to a lower end of the rod-shaped body than is the first part and which extends in an axial direction of the rod-shaped body so as to surround the rod-shaped body. Further, the nonslip part can have a length that is measured in a radial direction of the rod-shaped body and that is greater than the diameter of the bottom plate-side hole.

According to this configuration, the rod-shaped body includes a nonslip part which is provided so as to closer to a lower end of the rod-shaped body than is the first part and which extends in the axial direction of the rod-shaped body so as to surround the rod-shaped body. This makes it possible to, even in a case where the rod-shaped body is lifted by the cover, prevent the rod-shaped body from dropping from the bottom plate-side hole during the lifting of the cover from the bottom plate while the rod-shaped body is inserted in the bottom plate-side hole and in the cover-side hole. Furthermore, the removably provided nonslip part makes it possible to pass the rod-shaped body through the bottom plate-side hole and the cover-side hole while no nonslip part is fitted to the rod-shaped body. This makes it easier to pass the rod-shaped body through the bottom plate-side hole and the cover-side hole.

Further, the rod-shaped body can include a handle which is provided so as to be closer to an upper end of the rod-shaped body than is the second part and which extends in an axial direction of the rod-shaped body so as to surround the rod-shaped body.

According to this configuration, the rod-shaped body includes a handle which is provided so as to closer to an upper end of the rod-shaped body than is the second part and which extends in the axial direction of the rod-shaped body so as to surround the rod-shaped body. This makes it possible to easily use the rod-shaped body by grabbing the handle with one hand, and therefore improve workability.

A detachment method in accordance with an aspect of the present invention is a method for detaching a cover from a bottom plate, together with which the cover forms a reactor in which a silicon rod is contained upright, the method including: an inserting step of inserting a rod-shaped body into a bottom plate-side hole provided in a surrounding area of the bottom plate and into a cover-side hole provided in a surrounding area of the cover so as to face the bottom plate-side hole; and a lifting step of lifting the cover while the rod-shaped body is inserted in the bottom plate-side hole and in the cover-side hole.

According to this configuration, by carrying out the inserting step and the lifting step, the cover is lifted from the bottom plate while the rod-shaped body is inserted in the bottom plate-side hole provided in the surrounding area of the bottom plate and in the cover-side hole provided in the surrounding area of the cover so as to face the bottom plate-side hole. Accordingly, the cover is lifted along the rod-shaped body, and the cover is therefore substantially vertically lifted. The detachment method therefore makes it possible to prevent the cover from laterally swinging during the lifting of the cover, even in a case where the silicon rod is in contact with an inner wall of the reactor.

Further, in the detachment method, the rod-shaped body that has been inserted into the surrounding area of the bottom plate and into the surrounding area of the cover can include two or more rod-shaped bodies that are inserted at respective places at substantially regular intervals in a circumferential direction of the bottom plate and of the cover. This configuration makes it possible to stably prevent the cover from laterally swinging during the lifting of the cover.

A silicon rod manufacturing method in accordance with an aspect of the present invention is a method for manufacturing a silicon rod, the method including a detaching step of detaching a cover from a bottom plate, together with which the cover forms a reactor in which the silicon rod is contained upright, the detaching step of including: an inserting step of inserting a rod-shaped body into a bottom plate-side hole provided in a surrounding area of a bottom plate which forms the reactor in which a silicon rod is contained and into a cover-side hole provided in a surrounding area of the cover so as to face the bottom plate-side hole; and a lifting step of lifting the cover while the rod-shaped body is inserted into the bottom plate-side hole and into the cover-side hole.

According to this configuration, by carrying out, in the silicon rod manufacturing method, the detaching step of that includes the inserting and lifting steps, the cover is lifted from the bottom plate while the rod-shaped body is insert in the bottom plate-side hole provided in the surrounding area of the bottom plate and in the cover-side hole provided in the surrounding area of the cover so as to face the bottom plate-side hole. Accordingly, the cover is lifted along the rod-shaped body, and the cover is therefore substantially vertically lifted. The silicon rod manufacturing method therefore makes it possible to prevent the cover from laterally swinging during lifting of the cover, even in a case where the silicon rod is in contact with an inner wall of the reactor.

Further, the rod-shaped body that has been inserted into the surrounding area of the bottom plate and into the surrounding area of the cover in the inserting step of the silicon rod manufacturing method includes two or more rod-shaped bodies that are inserted at respective places at substantially regular intervals in a circumferential direction of the bottom plate and of the cover. This configuration makes it possible to stably prevent the cover from laterally swinging during lifting of the cover.

The present invention is not limited to the embodiments above, but can be altered in various ways by a skilled person within the scope of the claims. The present invention encompasses, in its technical scope, any embodiment derived by combining technical means disclosed in differing embodiments.

### Reference Signs List

- 10, 10A: Rod-shaped body
- 11: First part
- 12: Second part
- 50,60: Jig
- 51, 61: Attachment part
- 100: Reactor
- 101: Bottom plate
- 102: Bottom plate flange
- 102a: Bottom plate-side hole
- 103: Cover
- 103a: Side-wall surface (outer wall)
- 104: Cover flange
- 104a: Cover-side hole
- 105: Electrode
- 106: Projection
- 110: Silicon rod
- 200: Protective structure
- 201: First frame body (frame body)
- 204: Protective wall surface
- 205: Protective plate
- 206: Dividing line
- 207: Takeout window
- 210: Storage space

## Claims

1. A rod-shaped body to be used to lift a cover so as to detach the cover from a bottom plate, together with which the cover forms a reactor in which a silicon rod is contained upright, the rod-shaped body comprising:
- a first part to be inserted into a bottom plate-side hole provided in a surrounding area of the bottom plate; and
- a second part to be inserted into a cover-side hole provided in a surrounding area of the cover so as to face the bottom plate-side hole.

2. A jig comprising
- an attachment part to be attached in the surrounding area of the bottom plate so that the bottom plate-side hole into which the rod-shaped body according to claim 1 is to be inserted is provided in the surrounding area of the bottom plate,
- the jig having a hole formed therein that serves as the bottom plate-side hole.

3. The jig according to claim 2, further comprising a supporting part, provided in a lower part of the jig, for supporting a lower end part of the rod-shaped body.

4. A jig comprising
- an attachment part to be attached in a surrounding area of the cover so that the cover-side hole into which the rod-shaped body according to claim 1 is to be inserted is provided in the surrounding area of the cover,
- the jig having a hole formed therein that serves as the cover-side hole.

5. The rod-shaped body according to claim 1, wherein
- the first part is inserted into the bottom plate-side hole that is formed in a flange provided to the bottom plate, and
- the second part is inserted into the cover-side hole that is formed in a flange provided to the cover.

6. The rod-shaped body according to claim 1, wherein a distance from an outer edge of the bottom plate to the bottom plate-side hole and a distance from an outer wall of the cover to the cover-side hole are each greater than a distance from the outer wall of the cover to an end of a projection provided on the outer wall of the cover, the end facing away from the outer wall of the cover.

7. The rod-shaped body according to claim 1, wherein a height from the bottom plate to an upper end of the rod-shaped body as measured in a state in which the rod-shaped body is inserted in the bottom plate-side hole and in the cover-side hole is greater than a height from the bottom plate to an upper end of the silicon rod that stands upright.

8. The rod-shaped body according to claim 7, wherein
- the rod-shaped body includes a nonslip part which is removably provided so as to be closer to a lower end of the rod-shaped body than is the first part and which extends in an axial direction of the rod-shaped body so as to surround the rod-shaped body, and
- the nonslip part has a length that is measured in a radial direction of the rod-shaped body and is greater than a diameter of the bottom plate-side hole.

9. The rod-shaped body according to claim 1, wherein the rod-shaped body includes a handle which is provided so as to be closer to an upper end of the rod-shaped body than is the second part and which extends in an axial direction of the rod-shaped body so as to surround the rod-shaped body.

10. A method for detaching a cover from a bottom plate, together with which the cover forms a reactor in which a silicon rod is contained upright, the method comprising:
- an inserting step of inserting a rod-shaped body into a bottom plate-side hole provided in a surrounding area of the bottom plate and into a corresponding cover-side hole provided in a surrounding area of the cover so as to face the bottom plate-side hole; and
- a lifting step of lifting the cover while the rod-shaped body is inserted in the bottom plate-side hole and in the cover-side hole.

11. The method according to claim 10, wherein the rod-shaped body which has been inserted into the surrounding area of the bottom plate and into the surrounding area of the cover includes two or more rod-shaped bodies that are inserted at respective places at substantially regular intervals in a circumferential direction of the bottom plate and of the cover.

12. A method for manufacturing a silicon rod, comprising a detaching step of detaching a cover from a bottom plate, together with which the cover forms a reactor in which the silicon rod is contained upright,
- the detaching step including:
- an inserting step of inserting a rod-shaped body into a bottom plate-side hole provided in a surrounding area of the bottom plate which forms the reactor in which the silicon rod is contained and into a cover-side hole provided in a surrounding area of the cover so as to face the bottom plate-side hole; and
- a lifting step of lifting the cover while the rod-shaped body is inserted into the bottom plate-side hole and into the cover-side hole.

13. The method according to claim 12, wherein the rod-shaped body which has been inserted into the surrounding area of the bottom plate and into the surrounding area of the cover in the inserting step includes two or more rod-shaped bodies that are inserted at respective places at substantially regular intervals in a circumferential direction of the bottom plate and of the cover.
